# EUROPEAN PATENT APPLICATION

(11) **EP 2 924 740 A1**
(43) Date of publication of application: **30.09.2015**
(21) Application number: 13856809.2
(22) Date of filing: 19.11.2013
(51) Int. Cl.: H01L 31/0224, H01L 31/05

(54) **PHOTOVOLTAIC APPARATUS**

(30) Priority: 21.11.2012 JP 2012255121
(71) Applicant: Choshu Industry Co., Ltd., Sanyo-onoda-shi Yamaguchi 7578511 (JP); Namics Corporation, Niigata-shi, Niigata 950-3131 (JP)
(72) Inventor: HASHIMOTO Kimikazu, Sanyo-onoda-shi Yamaguchi 757-8511 (JP); OUCHI Masazumi, Sanyo-onoda-shi Yamaguchi 757-8511 (JP); SAKAMOTO Koji, Osaka-shi Osaka 558-0023 (JP); MURAMATSU Kazuo, Niigata-shi Niigata 950-3131 (JP)
(74) Representative: Vossius & Partner Patentanwälte Rechtsanwälte mbB
(86) International application number: PCT/JP2013/081145
(87) International publication number: WO 2014/080894

(57) **Abstract**

A photovoltaic apparatus 10 includes: a plurality of photovoltaic elements 11 having transparent conductive oxide layers 18, 19 and generating electrical power by light irradiation; and power collecting members provided on the front and back of each of the photovoltaic elements 11, wherein the power collecting members on the front sides are provided with finger electrodes 27 and a plurality of metallic conductor wires 28, the finger electrodes 27 formed on top of the transparent conductive oxide layers 18 in parallel by gravure offset printing, the thickness of the finger electrodes 27 formed to be 5 µm or less, the metallic conductor wires 28 orthogonally joined to the finger electrodes 27, and wherein the metallic conductor wires 28 are extended further in one direction and joined to one of the power collecting members provided on the back sides of the adjoining photovoltaic elements 11 to be connected in series.

## Description

### TECHNICAL FIELD

The present invention relates to a photovoltaic apparatus.

### BACKGROUND ART

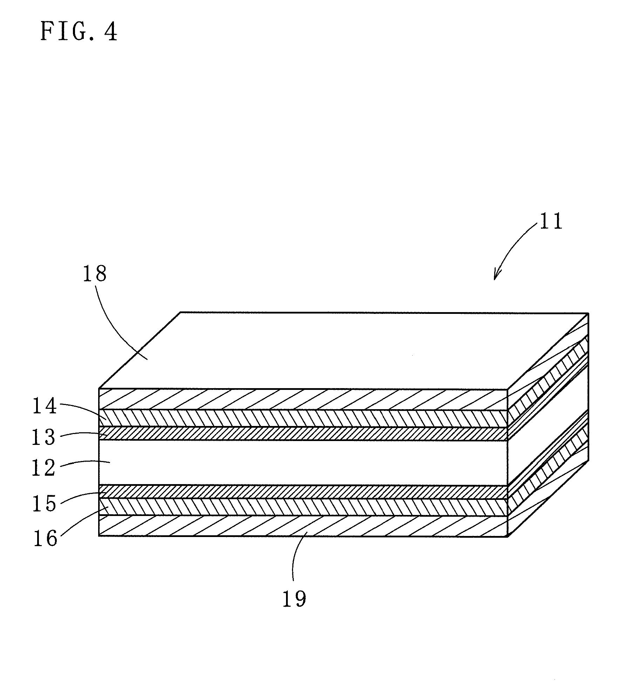

Currently, as a clean energy source that does not generate gas such as CO₂, photovoltaic apparatuses have been brought to attention. Among them, heterojunction photovoltaic apparatuses having high power-generation efficiencies have been being widely used. These photovoltaic apparatuses each have a plurality of photovoltaic elements 11, and each of the photovoltaic elements 11, as illustrated in FIG. 4, is provided with a p-type amorphous silicon-based thin film layer 14 on one face (upper face) of an n-type monocrystal silicon substrate (c-Si) 12 through an intrinsic amorphous silicon layer (i layer) 13, and an n-type amorphous silicon-based thin film layer 16 on the other face (lower face) of the n-type monocrystal silicon substrate (c-Si) 12 through an intrinsic amorphous silicon layer (i layer) 15, and has a transparent conductive oxide layer 18 on top of the p-type amorphous silicon-based thin film layer 14 and a transparent conductive oxide layer 19 underneath the n-type amorphous silicon-based thin film layer 16.

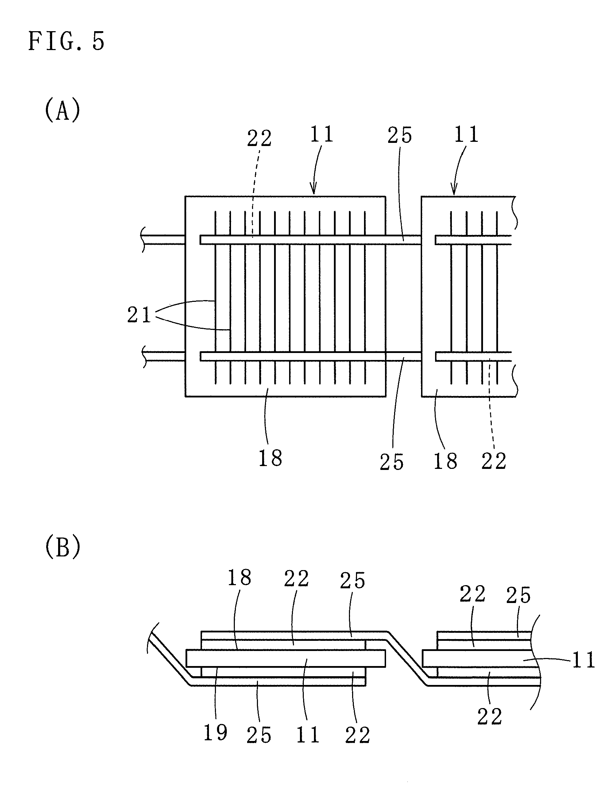

As illustrated in FIGS. 5(A) and 5(B), the surface of each of the transparent conductive oxide layers 18 and 19 is provided with a power collecting member consisting of finger electrodes 21 for gathering generated electrical power and bus bar electrodes 22 to be connected to the finger electrodes 21 (see Patent Literatures 1 and 2). The finger electrodes 21 (regular width is 50 to 100 µm, regular height is 50 µm or less) and the bus bar electrodes 22 (regular width is 0.5 to 2 mm, regular height is the same as that of the finger electrodes 21) are simultaneously formed by screen printing. The plurality of photovoltaic elements 11 are connected in series through interconnectors 25, heightening generated voltage of a photovoltaic apparatus as a whole.

### CITATION LIST

### Patent Literature

Patent Literature 1: Japanese Unexamined Patent Application Publication No. 2005-317886
Patent Literature 2: Japanese Unexamined Patent Application Publication No. 2012-054442

### SUMMARY OF INVENTION

### Technical Problem

The finger electrodes 21 and the bus bar electrodes 22 each consist of silver paste which is a conductive adhesive. Silver paste, when having the same cross-sectional areas, has a larger electric resistance than regular metallic conductors (e.g., copper) and the like. On the other hand, since silver paste is non-translucent, when the widths of the finger electrodes 21 and the bus bar electrodes 22 are increased, light-shielding rate increases and power generation efficiency decreases.

Therefore, cross-sectional areas have been acquired by repeating screen printing a plurality of times, however, there has been a problem in that in order to form a high-height power collecting member, a large amount of silver paste has become required, which has led to high cost of raw materials. Additionally, print accuracy of screen printing is low, and repeated printing at a same position gradually increases a width, which has led to another problem in that the finger electrodes 21 have become formed with widths larger than necessary and light-shielding rate has increased.
Moreover, in order to connect the adjacent photovoltaic elements 11, there has been a need to provide the interconnectors 25 along the bus bar electrodes 22 aside from the bus bar electrodes 22.

The present invention has been made in view of the above circumstances, and an object thereof is to provide a photovoltaic apparatus that can be manufactured at a relatively low cost.

### Solution to Problem

In order to achieve the above object, according to a first aspect of the present invention, a photovoltaic apparatus includes: a plurality of photovoltaic elements each having transparent conductive oxide layers formed on the front and back thereof and generating electrical power by light irradiation; and power collecting members provided on the front and back of each of the photovoltaic elements. The photovoltaic apparatus further includes: finger electrodes provided to the power collecting members on the front sides, the finger electrodes being formed in parallel on top of the transparent conductive oxide layers on the front sides by gravure offset printing, the thickness of the finger electrodes being formed to be 5 µm or less; and a plurality of metallic conductor wires provided to the power collecting members on the front sides, the plurality of metallic conductor wires being joined to the finger electrodes in an orthogonal state, wherein the metallic conductor wires are extended further in one direction and joined to one of the power collecting members provided on the back sides of the adjoining photovoltaic elements to be connected in series.

Since gravure offset printing is used for the formation of the finger electrodes, it becomes possible to print thin films, which is difficult to do by screen printing.
It is preferable for the thickness of the finger electrodes to be 1 µm or more, and when the thickness of the finger electrodes is less than 1 µm, it becomes difficult to actually produce them, and besides, electric resistance increases. Additionally, when the thickness of the finger electrodes increases, usage amount of metal paste (e.g., silver paste) increases, which increases the material cost. The width w of the finger electrodes is, for example, 40 to 200 µm (more preferably, 100 to 200 µm).
Moreover, it is preferable to use copper (including alloy) for the metallic conductor wires, however, other metallic wires (aluminum wires, silver wires, nickel wires and the like) can be used alternatively.

According to a second aspect of the present invention, in the photovoltaic apparatus of the first aspect of the present invention, the metallic conductor wires have a diameter d of 80 to 400 µm, and are arranged at a pitch of 15 d or more and 15 mm or less. Here, when the diameter d of the metallic conductor wires is smaller than 80 µm, electric resistance becomes large. It is possible for the diameter d of the metallic conductor wires to exceed 400 µm, however, electric resistance becomes smaller than necessary, and light-shielding rate becomes large at the same time. Additionally, metallic conductor wires (e.g., copper wires) having plating of dissimilar metals on the surfaces thereof can be used alternatively.

According to a third aspect of the present invention, in the photovoltaic apparatuses of the first and the second aspects of the present invention, a low-melting-point metal (e.g., solder) is used for the joining of the metallic conductor wires and the finger electrodes. The low-melting-point metal in this case is formed on the metallic conductor wires by means of coating treatment, and it is preferable for the thickness of the low-melting-point metal to be approximately 0.05- to 0.2-fold of the diameter of the metallic conductor wires.

In the photovoltaic apparatuses according to the first to third aspects of the present invention, by using a large number of metallic conductor wires as conventional bus bar electrodes, reduction in resistance can be achieved, and a photovoltaic apparatus having higher efficiency can be provided.

### Advantageous Effects of Invention

In the case of the photovoltaic apparatuses according to the present invention, since the finger electrodes are formed by using gravure offset printing, the width of each finger electrode can be made substantially constant and the thickness can accurately be made thin, and what is more, since bus bar electrodes are eliminated and the metallic conductor wires are used instead, usage amount of the conductive adhesive (e.g., silver paste) has decreased, making it possible to manufacture a photovoltaic apparatus at a lower cost.

Additionally, since the metallic conductor wires are extended further in one direction and joined to one of the power collecting members on the back sides of the adjoining photovoltaic elements, conventional interconnectors have become unnecessary, and assembling and manufacturing of a photovoltaic apparatus have become easier.

### BRIEF DESCRIPTION OF DRAWINGS

FIG. 1 is a plan view of a photovoltaic apparatus according to one embodiment of the present invention.
FIG. 2 is a side view of the same photovoltaic apparatus.
FIG. 3 is a cross-sectional view of A to A' in FIG. 1.
FIG. 4 is a schematic view of a photovoltaic element used for a photovoltaic apparatus according to a conventional example.
FIGS. 5(A) and 5(B) are a plan view and a side view, respectively, of the same photovoltaic apparatus.

### DESCRIPTION OF EMBODIMENTS

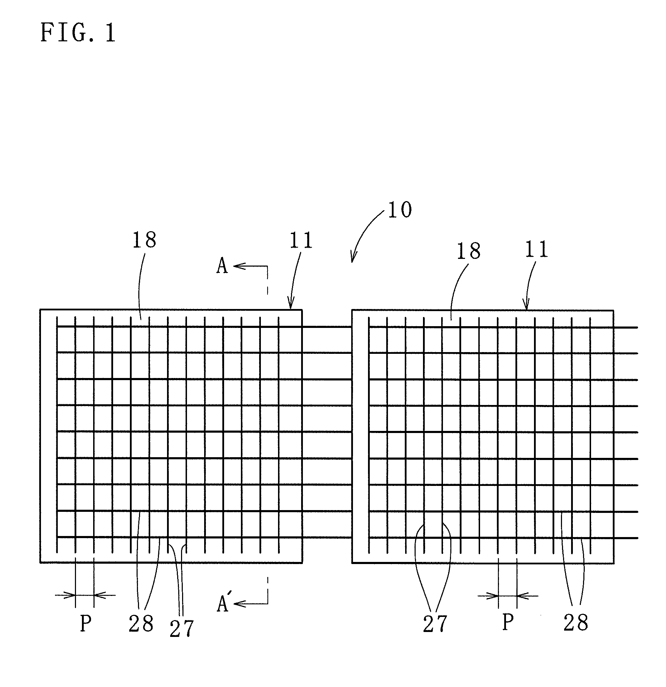

Next, with reference to the accompanying drawings, descriptions will be given on embodiments of the present invention. Components same as those of the photovoltaic apparatus according to the conventional example will be indicated by the same numerals.
As illustrated in FIGS. 1, 2 and 3, a photovoltaic apparatus 10 according to one embodiment of the present invention has a plurality of photovoltaic elements 11 to be connected in series. Each of these photovoltaic elements 11 is structured in the same way as the one illustrated in FIG. 4 (a heterojunction solar cell), and has an n-type monocrystal silicon substrate (c-Si) 12 in the middle, an intrinsic amorphous silicon layer 13 on top of the n-type monocrystal silicon substrate (c-Si) 12, an intrinsic amorphous silicon layer 15 underneath the n-type monocrystal silicon substrate (c-Si) 12, a p-type amorphous silicon-based thin film layer 14 on the outer side of the intrinsic amorphous silicon layer 13, and an n-type amorphous silicon-based thin film layer 16 on the outer side of the intrinsic amorphous silicon layer 15, and has a transparent conductive oxide layer 18 on the upper face and a transparent conductive oxide layer 19 on the lower face.

When light (e.g., sunlight) is irradiated to the surface of each of these photovoltaic elements 11, potential differences occur between the transparent conductive oxide layers 18 and 19 on the front and back, and electrical power becomes generated. Electromotive force of a single photovoltaic element 11 is as small as approximately 0.7 V. Thus, the plurality of photovoltaic elements 11 are connected in series in order to obtain predetermined voltage. Since these structures are well known, detailed descriptions will be omitted.

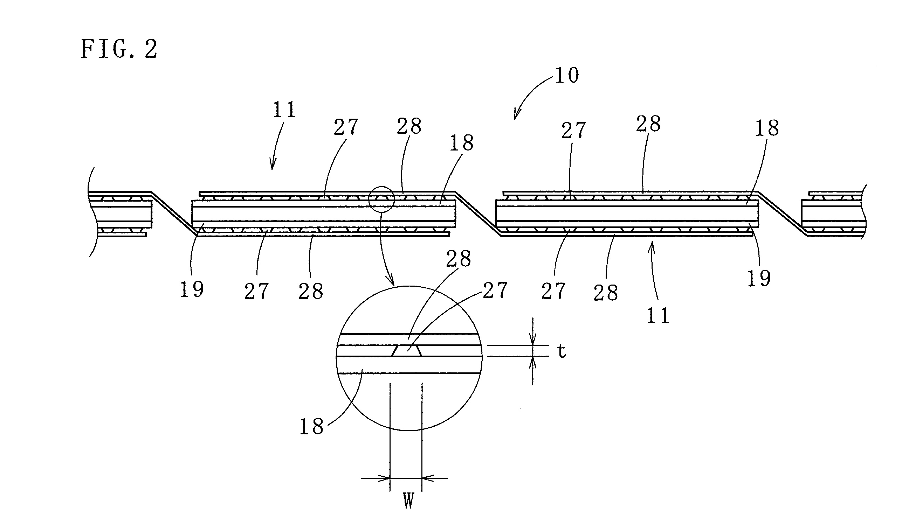

On the front and back of each of the photovoltaic elements 11, the transparent conductive oxide layers 18 and 19 are formed, and as illustrated in FIGS. 1 and 2, the surfaces of the transparent conductive oxide layers 18 and 19 include a plurality of finger electrodes 27 and a plurality of metallic conductor wires 28 put on the plurality of finger electrodes 27, the finger electrodes 27 and the metallic conductor wires 28 are respectively arranged in parallel at equal intervals. In this embodiment, by the plurality of finger electrodes 27 composed of thin lines and the plurality of metallic conductor wires 28 arranged orthogonal to the finger electrodes 27, the power collecting members on the front and back sides are formed. Each of the power collecting members on the front sides is electrically joined to each transparent conductive oxide layer 18 to be formed on the front side of each of the photovoltaic elements 11. Each of the power collecting members on the back sides is electrically joined to each transparent conductive oxide layer 19 to be formed on the back side of each of the photovoltaic elements 11. The power collecting members on the back sides can be different from those on the front sides.

Here, as illustrated in FIG. 2, the finger electrodes 27 are formed by printing silver paste that is an example of metal pastes. The thickness (height) t of each finger electrode 27 is 1 µm or more and 5 µm or less, the width w thereof is 40 to 200 µm (more preferably, 100 to 200 µm, and even 50 to 150 µm), and each pitch p between the finger electrodes 27 is approximately 10- to 20-fold of the width w. The finger electrodes 27 block out light, w/px100 (see FIGS. 1 and 2) expresses a function of light-shielding rate (%), and it is preferable for the light-shielding rate to be 10% or less.

When the cross-sectional area of each finger electrodes 27 is made small, usage amount of silver paste decreases in proportion to the thickness, and it becomes possible to provide an inexpensive photovoltaic apparatus that requires smaller usage amount of silver paste. However, making the thickness extremely thin lowers fill factor (FF), therefore, it is desirable to determine the width w and the thickness t of the finger electrodes 27 in such a manner that the fill factor does not become lowered too much.

In this case, in order to reduce the thickness t of the finger electrodes 27, the technique of gravure offset printing (gravure printing) is used. Reducing the thickness t of the finger electrodes 27 allows for a reduction in usage amount of silver paste at the time of manufacturing the photovoltaic apparatus 10.

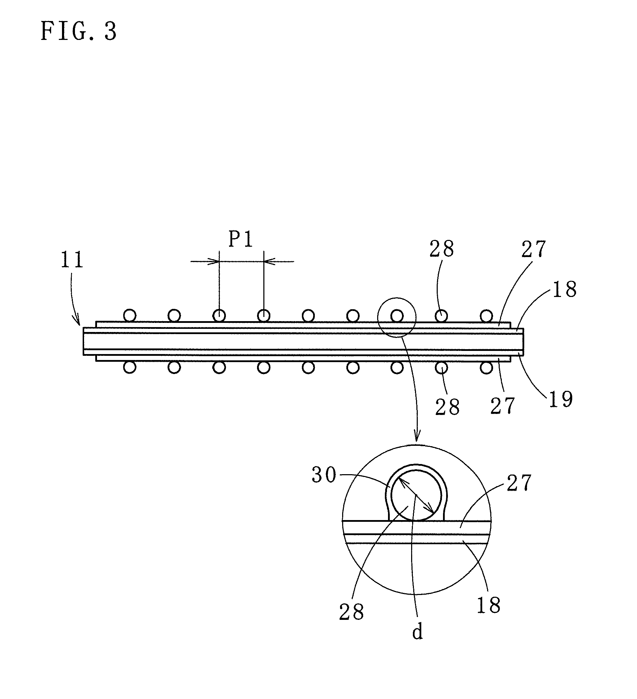

As illustrated in FIG. 3, on top of the plurality of finger electrodes 27 provided on the front side (and the back side) of each photovoltaic element 11 at small pitches, the plurality of metallic conductor wires 28 are arranged in parallel. The diameter d of these metallic conductor wires 28 is from 80 to 400 µm, and the metallic conductor wires 28 are wired at a pitch p1 of 15 d or more and 15 mm or less (e.g., pitches between the metallic conductor wires 28 are 4 mm).

Here, when the pitches between the metallic conductor wires 28 become large, power collection areas of the finger electrodes 27 become long and the photovoltaic elements 11 become affected by resistance loss. When the pitches between the metallic conductor wires 28 become small, light-shielding rate increases. Therefore, in view of a balance between the two, it is preferable to design with the light-shielding rate of 5 to 10%. Also, the metallic conductor wires 28 and the finger electrodes 27 are joined by a low-melting-point metal (e.g., solder) 30.

The low-melting-point metal 30 is, as illustrated in FIG. 3, with a predetermined thickness, preliminarily coated around the metallic conductor wires 28, and by melting the low-melting-point metal 30 through heating at a temperature of approximately 200°C, the metallic conductor wires 28 coated with the low-melting-point metal 30 become joined to the finger electrodes 27.

The metallic conductor wires 28 on the front sides of the photovoltaic elements 11 are extended further in one direction, and joined to the metallic conductor wires 28 on the back sides of the adjoining photovoltaic elements 11. Here, the state of "being joined" includes the case where metallic conductor wires on the front sides of photovoltaic elements and on the back sides of adjoining photovoltaic elements are formed by a single metallic conductor wire, aside from the case where separate metallic conductor wires are connected to one another.

In this embodiment, unlike the conventional way, a conductive adhesive is not used for the power collecting members (i.e., bus bar electrodes), and the metallic conductor wires are used instead. Thus, bending becomes enabled, and interconnectors and the like become unnecessary, making the manufacturing easier.

As described hereinbefore, the light-shielding rate in view of only the finger electrodes 27 is (w/p)×100 (%). Also, when the diameter of the metallic conductor wires 28 is indicated by d, and the pitches between the metallic conductor wires 28 by p1, the light-shielding rate in view of the finger electrodes 27 and the metallic conductor wires 28 is approximately {100(w/p)+100(d/p1)}%. It is preferable for the sum of these light-shielding rates to be 10% or less. Additionally, the cross-section of the metallic conductor wires 28 is circular. However, using metallic conductor wires having a rectangular cross-section, especially a longitudinal oblong cross-section allows for lowering of light-shielding rate while maintaining electric resistance.

Table 1 illustrates a working example performed to confirm the functions and effects of the present invention. No.1 to No. 7 each illustrate the cases where the height of finger electrodes is 0.1 µm, 0.3 µm, 0.5 µm, 1 µm, 3 µm, 5 µm and 10 µm. When the height of the finger electrodes is less than 1 µm, efficiency (η) also decreases, and it becomes hard to make the thickness less than 1 µm and constant even by the gravure offset printing.
On the other hand, when the thickness of the finger electrodes is further increased, usage amount of silver increases, which increases the manufacturing cost.

**[Table 1]**

| | Height of Finger Electrodes | Isc/A | Voc/V | FF | Rs/Ω | η/% |
|---|---|---|---|---|---|---|
| No.1 | 0.1 µm | 9.031 | 0.724 | 0.732 | 6.20E-03 | 19.67 |
| No.2 | 0.3 µm | 9.032 | 0.723 | 0.743 | 5.51 E-03 | 19.94 |
| No.3 | 0.5 µm | 9.031 | 0.725 | 0.752 | 5.26E-03 | 20.23 |
| No.4 | 1 µm | 9.035 | 0.726 | 0.761 | 4.92E-03 | 20.51 |
| No.5 | 3 µm | 9.034 | 0.724 | 0.766 | 4.45E-03 | 20.59 |
| No.6 | 5 µm | 9.045 | 0.725 | 0.772 | 4.41 E-03 | 20.80 |
| No.7 | 10 µm | 9.038 | 0.726 | 0.781 | 4.30E-03 | 21.06 |

The present invention is not limited to the above-described embodiment, and the structure thereof can be changed without altering the gist of the present invention. For example, in the above-described embodiment, copper wires are used as the metallic conductor wires, however, aluminum wires, nickel wires and the like can alternatively be used. Additionally, plating can be applied to the surfaces of the metallic conductor wires. Moreover, although silver paste is used as the conductive adhesive in producing of the finger electrodes, other conductive adhesives are usable as well.

### REFERENCE SIGNS LIST

10: photovoltaic apparatus, 11: photovoltaic element, 12: n-type monocrystal silicon substrate, 13: intrinsic amorphous silicon layer, 14: p-type amorphous silicon-based thin film layer, 15: intrinsic amorphous silicon layer, 16: n-type amorphous silicon-based thin film layer, 18, 19: transparent conductive oxide layer, 21: finger electrode, 22: bus bar electrode, 25: interconnector, 27: finger electrode, 28; metallic conductor wire, 30: low-melting-point metal

## Claims

1. A photovoltaic apparatus, comprising:
a plurality of photovoltaic elements each having transparent conductive oxide layers formed on the front and back thereof and generating electrical power by light irradiation; and
power collecting members provided on the front and back of each of the photovoltaic elements,
the photovoltaic apparatus, further comprising:
finger electrodes provided to the power collecting members on the front sides, the finger electrodes being formed in parallel on top of the transparent conductive oxide layers on the front sides by gravure offset printing, the thickness of the finger electrodes being formed to be 5 µm or less; and
a plurality of metallic conductor wires provided to the power collecting members on the front sides, the metallic conductor wires being joined to the finger electrodes in an orthogonal state, wherein
the metallic conductor wires are extended further in one direction and joined to one of the power collecting members provided on the back sides of the adjoining photovoltaic elements to be connected in series.

2. The photovoltaic apparatus according to claim 1, wherein
the metallic conductor wires have a diameter d of 80 to 400 µm, and are arranged at a pitch of 15 d or more and 15 mm or less.

3. The photovoltaic apparatus according to claim 1 or 2, wherein
a low-melting-point metal is used for the joining of the metallic conductor wires and the finger electrodes.
